# EUROPÄISCHE PATENTSCHRIFT

(11) **EP 1 419 282 B1**
(45) Veröffentlichungstag und Bekanntmachung des Hinweises auf die Patenterteilung: **19.01.2005**
(21) Anmeldenummer: 02767115.5
(22) Anmeldetag: 22.08.2002
(51) Int. Cl.: C23C 14/06

(54) **VERFAHREN ZUR HERSTELLUNG EINER LEUCHTSTOFFSCHICHT**
METHOD FOR PRODUCING A FLUORESCENT MATERIAL LAYER
PROCEDE POUR LA PRODUCTION D'UNE COUCHE DE SUBSTANCE FLUORESCENTE

(30) Priorität: 24.08.2001 DE 10141522
(43) Veröffentlichungstag der Anmeldung: 19.05.2004
(73) Patentinhaber: SIEMENS AKTIENGESELLSCHAFT, 80333 München (DE)
(72) Erfinder: FUCHS, Manfred, 90459 Nürnberg (DE); HELL, Erich, 89537 Gingen (DE); MATTERN, Detlef, 91056 Erlangen (DE); SCHMITT, Bernhard, 96328 Küps (DE)
(86) Internationale Anmeldenummer: PCT/DE2002/003078
(87) Internationale Veröffentlichungsnummer: WO 2003/018863

(56) Entgegenhaltungen:
- US-A- 6 100 506
- PATENT ABSTRACTS OF JAPAN vol. 017, no. 549 (E-1443), 4. Oktober 1993 (1993-10-04) -& JP 05 159878 A (HITACHI LTD), 25. Juni 1993 (1993-06-25)
- DATABASE WPI Section Ch, Week 198817 Derwent Publications Ltd., London, GB; Class L03, AN 1988-116851 XP002235910 -& JP 63 064290 A (HITACHI LTD), 22. März 1988 (1988-03-22)
- PATENT ABSTRACTS OF JAPAN vol. 1996, no. 01, 31. Januar 1996 (1996-01-31) & JP 07 240149 A (NEC KANSAI LTD), 12. September 1995 (1995-09-12)

## Beschreibung

Die Erfindung betrifft ein Verfahren zur Herstellung einer Leuchtstoffschicht und eine Vorrichtung zur Durchführung des Verfahrens.

Bei der Verwendung von Halogeniden und Dotanten mit unterschiedlichem Sättigungsdampfdruck, z.B. CsI/TlI oder CsBr/EuBr₂, tritt das Problem auf, dass beim Verdampfen aus der Schmelze die Verbindungen mit dem höheren Sättigungsdampfdruck schneller.entweichen als die Verbindungen mit dem niedrigeren Sättigungsdampfdruck. In den auf dem Substrat abgeschiedenen Kristallen sind die Dotierungsstoffe ungleichmäßig verteilt. Z.B. weisen die Kristalle an ihrer Oberfläche einen höheren Gehalt an Dotierstoffen auf als im Inneren.

Um diesem Problem entgegenzutreten, ist es aus der DE 44 29 013 A1 bekannt, mittels einer Röntgenmessvorrichtung die Schichtdicke der Leuchtstoffschicht während des Aufdampfens zu messen. In Abhängigkeit des Messergebnisses wird die Bedampfungsrate zur Erzielung einer möglichst gleichmäßigen Schichtdicke und einer vollständigen Verdampfung der Schmelze geregelt.

Aus der DE 195 16 450 C1 ist des weiteren ein Verfahren zum Herstellen einer aus CsI:Tl bestehenden Leuchtstoffschicht bekannt. Dabei wird der Druck in der Bedampfungsanlage zumindest während des Bedampfens höher gehalten als der Sättigungsdampfdruck des eingesetzten Tl. Mit diesem Verfahren lässt sich eine Leuchtstoffschicht verbesserter Lichtausbeute herstellen.

Die bekannten Verfahren eignen sich insbesondere zum Aufdampfen von aus Alkalihalogeniden gebildeten Verbindungen, deren Sättigungsdampfdrücke nicht all zu unterschiedlich sind. Sie eignen sich jedoch nicht zur Herstellung von Leuchtstoffschichten aus Verbindungen, z.B. CsBr/EuBr₂, deren Sättigungsdampfdrücke sich erheblich voneinander unterscheiden.

Nach dem Stand der Technik ist es außerdem bekannt, Leuchtstoffschichten nach dem Aufdampfen "auszuheizen". Das Ausheizen bewirkt einen Ausgleich von Konzentrationsunterschieden des Dotierstoffs. Es wird ein optimaler Wert der Lichtausbeute oder der Speicherkapazität des Leuchtstoffs erreicht. - Nachteiligerweise ist der Ausschuss bei diesem Verfahren hoch. Außerdem ist die Lichtausbeute nicht an allen Orten, d.h. in x-y-Richtung, gleich groß. Insbesondere beim Einsatz der Leuchtstoffschicht als Röntgenbildverstärker kann es zu einer unerwünschten Verfälschung des Röntgenbilds kommen. Insoweit ist eine Variation der Lichtausbeute von höchstens 5% gegenüber einem Maximalwert der Lichtausbeute tolerierbar.

Aufgabe der Erfindung ist es, die Nachteile nach dem Stand der Technik zu beseitigen. Es soll insbesondere ein möglichst universelles und einfaches Verfahren zur Herstellung von Leuchtstoffschichten mit einer in x-y-Richtung im wesentlichen gleichmäßigen Lichtausbeute angegeben werden. Ein weiteres Ziel der Erfindung besteht darin, eine zur Durchführung des Verfahrens geeignete Vorrichtung anzugeben.

Diese Aufgabe wird durch die Merkmale der Ansprüche 1 und 12 gelöst. Zweckmäßige Ausgestaltungen ergeben sich aus den Merkmalen der Ansprüche 2 bis 10 und 13 sowie 14.

Nach Maßgabe der Erfindung ist ein Verfahren zur Herstellung einer Leuchtstoffschicht mit folgenden Schritten vorgesehen:
a) Abscheiden der Leuchtstoffschicht aus der Dampfphase auf ein Substrat,
b) ortsaufgelöstes Messen der Lichtausbeute und
c) ortsaufgelöstes Tempern der Leuchtstoffschicht an Orten, an denen die Lichtausbeute geringer als ein vorgegebener Wert ist.

Unter Ortsauflösung wird eine Auflösung in x-y-Richtung, d.h. in lateraler Richtung der Leuchtstoffschicht verstanden. Bei dem vorgegebenen Wert kann es sich z.B. um einen Minimalwert der Lichtausbeute handeln, welcher für die jeweilige Anwendung der Leuchtstoffschicht notwendig ist. Unter einem Leuchtstoff wird vorliegend ein Szintillator oder ein Speicherleuchtstoff verstanden. Ein solcher Leuchtstoff kann Anwendung finden zur Herstellung eines Röntgenbildverstärkers, von Verstärkerplatten, für Röntgenfilme oder in der computergestützten Radiologie.

Mit dem vorgeschlagenen Verfahren kann auf überraschend einfache Weise eine Leuchtstoffschicht hergestellt werden, die an allen Orten eine im wesentlichen gleiche Lichtausbeute aufweist. Das gelingt selbst bei Leuchtstoffschichten, welche in x-y-Richtung eine unterschiedliche Dicke aufweisen. Der Ausschuss kann mit dem vorgeschlagenen Verfahren erheblich vermindert werden.

In einer vorteilhaften Ausgestaltung werden die Schritte lit. b und lit. c wiederholt, bis die Lichtausbeute der Leuchtstoffschicht an allen Orten um höchstens 10%, vorzugsweise um höchstens 5%, geringer als der vorgegebene Wert ist. Eine solche Leuchtstoffschicht kann bei Röntgenbildverstärkern zum Einsatz kommen. - Der vorgegebene Wert kann ein beim Schritt lit. b gemessener Maximalwert sein. Die Lichtausbeute wird durch das ortsaufgelöste Tempern an den anderen Orten an den Maximalwert angeglichen.

Zweckmäßigerweise wird bei jeder Wiederholung eine erste Temperatur des ortsaufgelösten Temperns höher gewählt als beim vorhergehenden ortsaufgelösten Tempern. Die erste Temperatur kann bei jeder Wiederholung des ortsaufgelösten Temperns um 20-50° C höher gewählt werden. Die vorgenannten Merkmale beruhen auf der Erkenntnis, dass durch eine Erhöhung der ersten Temperatur die Lichtausbeute des Leuchtstoffs gesteigert werden kann. An Orten geringer Lichtausbeute kann so iterativ die Lichtausbeute erhöht werden, bis sie im wesentlichen dem vorgegebenen Wert entspricht. Statt einer Erhöhung der ersten Temperatur ist es auch möglich, bei einer Wiederholung der Schritte lit. b und lit. c die Haltezeit zu variieren. Selbstverständlich ist es auch möglich beide vorgenannten Parameter, d.h. die erste Temperatur und die Haltezeit, zur Erhöhung der Lichtausbeute zu variieren.

Nach einem weiteren Ausgestaltungsmerkmal wird die gesamte Leuchtstoffschicht vor dem Schritt lit. b bei einer zweiten Temperatur im Bereich von 150-250° C getempert. Ein solches Tempern der gesamten Leuchtstoffschicht dient einer Erhöhung des Mittelwerts der Lichtausbeute. Auch werden damit erhebliche lokale Unterschiede in der Lichtausbeute ausgeglichen. Die Schritte lit. b. und lit. c. müssen zum Ausgleich lokaler Unterschiede der Lichtausbeute nur wenige Male wiederholt werden.
Zur Erzielung einer gleichmäßigen Verteilung der Lichtausbeute in x-y-Richtung ist es zweckmäßig, die erste Temperatur beim Schritt lit. c höher zu wählen als die zweite Temperatur.

Vorteilhafterweise wird zum ortsaufgelösten Tempern ein aus einer Vielzahl von Heizelementen gebildetes Heizarray verwendet, wobei jedes Heizelement auf eine in Abhängigkeit eines zuvor ortsabhängigen gemessenen Werts der Lichtausbeute berechnete erste Temperatur eingestellt wird. Wenn die Lichtausbeute am das jeweilige Heizelement betreffenden Ort unterhalb des vorgegebenen Werts liegt, wird das Heizelement auf eine zuvor berechnete erste Temperatur aufgeheizt und für eine vorgegebene Haltezeit auf dieser Temperatur gehalten. Sofern an dem das jeweilige Heizelement betreffenden Ort die Lichtausbeute bereits dem vorgegebenen Wert entspricht, wird das Heizelement nicht aufgeheizt, d.h. dessen Temperatur wird auf Umgebungstemperatur eingestellt.

Es hat sich als zweckmäßig erwiesen, zum ortsaufgelösten Messen der Lichtausbeute einen Scanner oder eine CCD-Kamera zu verwenden. Bei dem Scanner kann es sich um einen LED-Scanner handeln. Unter Verwendung eines solchen Scanners oder einer CCD-Kamera kann die Verteilung der Lichtausbeute in x-y-Richtung ohne mechanisches Scannen der Leuchtstoffschicht erfolgen. D.h. es wird die Verteilung der Lichtausbeute im selben Moment erfasst und nachfolgend ausgewertet. Bei der Auswertung wird für jedes der Heizelemente die erste Temperatur für den nachfolgenden Temperschritt berechnet. Die Haltezeit kann fest vorgegeben oder ebenfalls als Ergebnis der Auswertung individuell vorgegeben werden. Die Auswertung kann automatisch mittels eines vorgegebenen Computer-Programms derart erfolgen, dass die Schritte lit. b und lit. c solange wiederholt werden, bis eine vorgegebene Verteilung der Lichtausbeute erreicht worden ist.

Nach einem weiteren Ausgestaltungsmerkmal ist die Leuchtstoffschicht aus einem dotierten Alkalihalogenid hergestellt. Das dotierte Alkalihalogenid kann aus der folgenden Gruppe ausgewählt sein: CsBr:Eu, CsI:Tl, CsI:Na, RbBr:Eu, RbBr:Tl. Selbstverständlich kann die Leuchtstoffschicht auch aus anderen zum Aufdampfen geeigneten Alkalihalogeniden hergestellt sein.

Zur Durchführung des erfindungsgemäßen Verfahrens ist nach weiterer Maßgabe der Erfindung eine Vorrichtung vorgesehen, mit einer Einrichtung zum ortsaufgelösten Messen der Lichtausbeute einer Leuchtstoffschicht, einem aus einer Vielzahl individuell ansteuerbarer Heizelemente gebildeten Heizarray und einer Einrichtung zum Ansteuern der Heizelemente in Abhängigkeit der gemessenen Werte der Lichtausbeute.

Mit der vorgeschlagenen Vorrichtung ist es möglich, weitgehend automatisch Leuchtstoffschichten mit einer gleichmäßigen Lichtausbeute in x-y-Richtung herzustellen.

Zweckmäßigerweise ist als weiterer Bestandteil der Vorrichtung eine Röntgenquelle zum Bestrahlen der Leuchtstoffschicht vorgesehen. Nach dem Bestrahlen der Leuchtstoffschicht kann mittels der Einrichtung zum ortsaufgelösten Messen der Lichtausbeute die Verteilung der Lichtausbeute in x-y-Richtung gemessen werden. Die Einrichtung zum ortsaufgelösten Messen der Lichtausbeute kann eine CCD-Kammera oder einen Scanner umfassen. Bei dem Scanner kann es sich um einen LED-Scanner handeln. Eine solche Einrichtung erlaubt ein schnelles ortsaufgelöstes Messen der Verteilung der Leuchtausbeute. Die vorgeschlagene Vorrichtung kann mittels eines Computer-Programms automatisiert gesteuert werden.

Nachfolgend wird ein Ausführungsbeispiel der Erfindung anhand der Zeichnung näher erläutert. Es zeigen:
- Fig. 1: eine Draufsicht auf ein Heizarray und
- Fig. 2: eine schematische Ansicht der wichtigsten Komponenten der Vorrichtung.

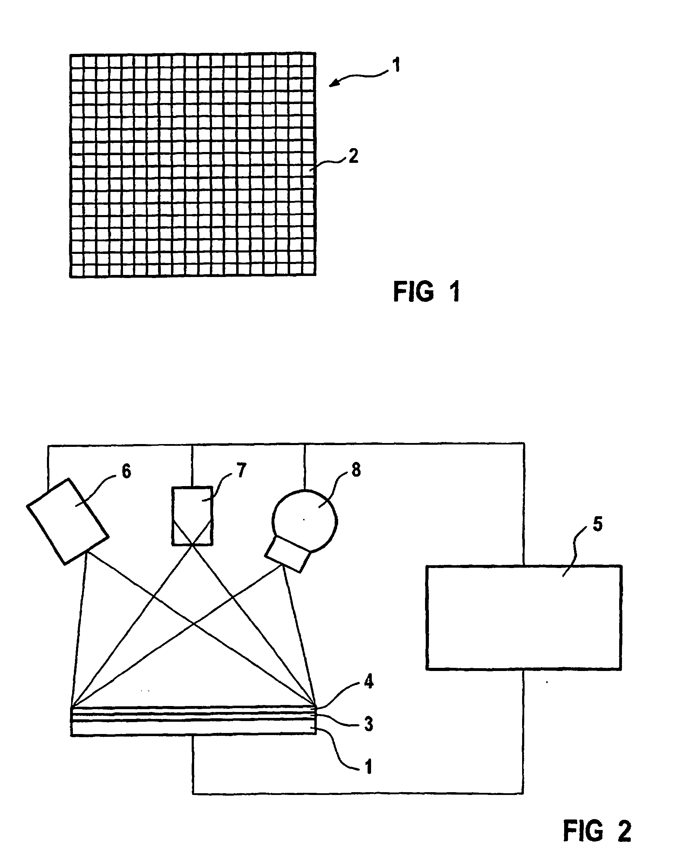

Fig. 1 zeigt ein Heizarray 1. Das Heizarray 1 umfasst eine Vielzahl von Heizelementen 2, die in Reihen und Spalten angeordnet sind. Die Heizelemente 2 sind vorzugsweise Widerstandsheizelemente. Deren Kantenlänge kann 1 bis 5 cm betragen. Jedes der Heizelemente 2 kann individuell auf eine vorgegebene Temperatur eingestellt werden.

Fig. 2 zeigt eine Vorrichtung zum ortsaufgelösten Tempern einer Leuchtstoffplatte, die aus einem Substrat 3 und einer darauf aufgebrachten Leuchtstoffschicht 4 gebildet ist. Bei dem Leuchtstoff kann es sich z.B. um CsBr:Eu handeln. Die Leuchtstoffplatte liegt auf dem Heizarray 1 auf. Die Heizelemente 2 des Heizarrays 1 sind mit einer Steuer- und Regeleinrichtung 5 verbunden. Ebenfalls mit der Steuer- und Regeleinrichtung 5 verbunden ist ein Scanner 6, vorzugsweise ein LED-Flächen-Scanner, eine Infrarotkamera 7 und eine Röntgenröhre 8. Statt des Scanners 6 kann auch eine CCD-Kamera vorgesehen sein.

### Die Funktion der Vorrichtung ist folgende:

Nach dem Auflegen der Leuchtstoffplatte auf das Heizarray 1 wird mittels der Steuer- und Regeleinrichtung 5 das Heizarray 1 auf eine einheitliche Temperatur von z.B. 170° C aufgeheizt. Die Temperatur wird für eine vorgegebene Heizzeit, z.B. eine Stunde (stimmt das?) gehalten. Die Temperatur kann mittels der Infrarotkamera 7 und der Steuer- und Regeleinrichtung 5 geregelt werden. Mittels des ersten Temperschritts wird die Lichtausbeute der Leuchtstoffschicht 4 auf einen vorgegebenen Mindestwert gebracht, der für die jeweilige Anwendung erforderlich ist.

Nach dem Abkühlen der Leuchtstoffschicht 3 wird diese mittels der Röntgenröhre 8 für eine vorgegebene Zeit mit einer vorgegebenen Energie bestrahlt. Das dabei erzeugte Lumineszenzlicht wird vom Scanner 6 erfasst. Mittels der Steuer- und Regeleinrichtung 5 wird die Lichtausbeute für jedes einem Heizelement 2 entsprechende Flächenelement der Leuchtstoffschicht erfasst. Die ermittelte Lichtausbeute wird verglichen mit einem vorgegebenen Wert. Besteht zwischen dem vorgegebenen Wert und dem ermittelten Wert eine Differenz, so wird eine Temperatur für das betreffende Heizelement 2 errechnet.

Die Heizelemente 2 werden gemäß der errechneten Tempertemperatur anschließend aufgeheizt und für eine vorgegebene Haltezeit auf der Tempertemperatur gehalten. Die Regelung der Tempertemperaturen erfolgt wiederum mittels der Infrarotkamera 7 und der Steuer- und Regeleinrichtung 5.

Nach dem Abkühlen der Leuchtstoffplatte wird diese mittels der Röntgenröhre 8 wiederum mit Röntgenstrahlung bestrahlt. Es wird erneut die Verteilung der Lichtausbeute in x-y-Richtung unter Verwendung des Scanners 6 erfasst und mit der Steuer- und Regeleinrichtung 5 ausgewertet. Diejenigen Flächenelemente der Leuchtstoffschicht 3, welche noch eine Differenz zu dem vorgegebenen Wert aufweisen, werden mittels der ihnen zugeordneten Heizelemente 2 in einem weiteren Durchgang aufgeheizt. Die Tempertemperatur ist dabei vorzugsweise höher gewählt als die Tempertemperatur im vorhergehenden Durchgang.

Das vorbeschriebene Verfahren wird solange wiederholt, bis eine vorgegebene maximale Tempertemperatur erreicht ist. Die maximale Tempertemperatur ist abhängig von der Zusammensetzung des Leuchtstoffs.

Mit dem vorgeschlagenen Verfahren kann einfach und schnell eine Leuchtstoffplatte hergestellt werden, deren Leuchtstoffschicht eine gleichmäßige Lichtausbeute in x-y-Richtung aufweist. Die Lichtausbeute variiert über die Fläche maximal bis zu 5%.

## Patentansprüche

1. Verfahren zur Herstellung einer Leuchtstoffschicht (4) mit folgenden Schritten:
a) Abscheiden der Leuchtstoffschicht (4) aus der Dampfphase auf ein Substrat (3),
b) ortsaufgelöstes Messen der Lichtausbeute und
c) ortsaufgelöstes Tempern der Leuchtstoffschicht (4) an Orten, an denen die Lichtausbeute geringer als ein vorgegebener Wert ist.

2. Verfahren nach Anspruch 1, wobei die Schritte lit. b und lit. c wiederholt werden, bis die Lichtausbeute der Leuchtstoffschicht (4) an allen Orten um höchsten 10%, vorzugsweise um höchstens 5%, geringer als der vorgegebene Wert ist.

3. Verfahren nach Anspruch 1 oder 2, wobei der vorgegebene Wert ein beim Schritt lit. b gemessener Maximalwert ist.

4. Verfahren nach einem der vorhergehenden Ansprüche, wobei bei jeder Wiederholung eine erste Temperatur des ortsaufgelösten Temperns höher gewählt wird als beim vorhergehenden ortsaufgelösten Tempern.

5. Verfahren nach einem der vorhergehenden Ansprüche, wobei die erste Temperatur bei jeder Wiederholung des ortsaufgelösten Temperns um 20 bis 50°C höher gewählt wird.

6. Verfahren nach einem der vorhergehenden Ansprüche, wobei die gesamte Leuchtstoffschicht (4) vor dem Schritt lit. b bei einer zweiten Temperatur im Bereich von 150 bis 250 °C getempert wird.

7. Verfahren nach einem der vorhergehenden Ansprüche, wobei die erste Temperatur beim Schritt lit. c höher gewählt wird als die zweite Temperatur.

8. Verfahren nach einem der vorhergehenden Ansprüche, wobei zum ortsaufgelösten Tempern ein aus einer Vielzahl von Heizelementen (2) gebildetes Heizarray (1) verwendet wird, wobei jedes Heizelement (2) auf eine in Abhängigkeit eines zuvor ortsabhängig gemessenen Werts der Lichtausbeute berechnete erste Temperatur eingestellt wird.

9. Verfahren nach einem der vorhergehenden Ansprüche, wobei zum ortsaufgelösten Messen der Lichtausbeute ein Scanner (6) oder eine CCD-Kamera verwendet wird.

10. Verfahren nach einem der vorhergehenden Ansprüche, wobei die Leuchtstoffschicht (4) aus einem dotierten Alkalihalogenid hergestellt ist.

11. Verfahren nach Anspruch 10, wobei das dotierte Alkalihalogenid aus der folgenden Gruppe ausgewählt ist: CsBr:Eu, CsI:Tl, CsI:Na, RbBr:Eu, RbBr:Tl.

12. Vorrichtung zur Durchführung des Verfahrens nach einem der vorhergehenden Ansprüche, mit einer mit der Einrichtung (6) zum ortsaufgelösten Messen der Lichtausbeute einer Leuchtstoffschicht (4), einem aus einer Vielzahl individuell ansteuerbarer Heizelemente (2) gebildeten Heizarray (1) und einer Einrichtung (5) zum Ansteuern der Heizelemente (2) in Abhängigkeit der gemessenen Werte der Lichtausbeute.

13. Vorrichtung nach Anspruch 12, wobei eine Röntgenquelle (8) zum Bestahlen der Leuchtstoffschicht (4) vorgesehen ist.

14. Vorrichtung nach Anspruch 12 oder 13, wobei die Einrichtung (6) zum ortsaufgelösten Messen der Lichtausbeute eine CCD-Kamera oder einen Scannen mit LED-Elementen umfasst.

## Claims

1. Method for producing a luminophore layer (4), comprising the following steps:
a) deposition of the luminophore layer (4) from the vaporisation phase onto a substrate (3),
b) locally resolved measurement of the light yield and
c) locally resolved tempering of the luminophore layer (4) at locations at which the light yield is less than a predefined value.

2. Method according to claim 1, wherein the steps b) and c) are repeated until the light yield of the luminophore layer (4) at all locations is at most 10%, preferably at most 5%, less than the predefined value.

3. Method according to claim 1 or 2, wherein the predefined value is a maximum value measured in step b).

4. Method according to one of the preceding claims, wherein at each repetition a first temperature of the locally resolved tempering is selected to be higher than in the preceding locally resolved tempering.

5. Method according to one of the preceding claims, wherein the first temperature for each repetition of the locally resolved tempering is selected 20 to 50° C higher.

6. Method according to one of the preceding claims, wherein the entire luminophore layer (4) is tempered at a second temperature in the range of 150 to 250° C before step b).

7. Method according to one of the preceding claims, wherein the first temperature in step c) is selected higher than the second temperature.

8. Method according to one of the preceding claims, wherein for locally resolved tempering a heating array (1) formed from a plurality of heating elements (2) is used, with each heating element (2) being set to a first temperature calculated as a function of a previous locally resolved measured value of the light yield.

9. Method according to one of the preceding claims, wherein a scanner (6) or a CCD camera is used for locally resolved measurement of the light yield.

10. Method according to one of the preceding claims, wherein the luminophore layer (4) is produced from a doped alkali halogenide.

11. Method according to claim 10, wherein the doped alkali halogenide is selected from the following group: CsBr:Eu, CsI:Tl, CsI:Na, RbBr:Eu, RbBr:Tl.

12. Device for implementing the method according to one of the preceding claims, said device comprising a further device (6) for locally resolved measurement of the light yield of a luminophore layer (4), a heating array (1) formed from a plurality of individually controllable heating elements (2), and a device (5) for controlling the heating elements (2) as a function of the measured values of the light yield.

13. Device according to claim 12, wherein an x-ray source (8) is provided for the purpose of irradiating the luminophore layer (4).

14. Device according to claim 12 or 13, wherein the device (6) for locally resolved measurement of the light yield comprises a CCD camera or a scanner having LED elements.

## Revendications

1. Procédé de fabrication d'une couche de substance luminescente (4), lequel procédé comporte les étapes suivantes consistant à :
a) déposer la couche de substance luminescente par dépôt en phase vapeur sur un substrat (3),
b) mesurer localement le rendement lumineux et
c) recuire localement la couche de substance luminescente (4) en des endroits où le rendement lumineux est inférieur à une valeur prédéterminée.

2. Procédé selon la revendication 1, dans lequel les étapes b et c sont répétées jusqu'à ce que le rendement lumineux de la couche de substance luminescence (4) soit en tout endroit inférieur de 10% au plus, avantageusement de 5% au plus, à la valeur prédéterminée.

3. Procédé selon la revendication 1 ou 2, dans lequel la valeur prédéterminée est une valeur maximale mesurée à l'étape b.

4. Procédé selon l'une des revendications précédentes, dans lequel à chaque répétition on choisit une première température de recuit local supérieure à celle du recuit local précédent.

5. Procédé selon l'une des revendications précédentes, dans lequel à chaque répétition du recuit local on choisit la première température supérieure de 20 à 50°C.

6. Procédé selon l'une des revendications précédentes, dans lequel on recuit toute la couche de substance luminescente (4) avant l'étape b à une deuxième température de l'ordre de 150 à de 250°C.

7. Procédé selon l'une des revendications précédentes, dans lequel on choisit la première température à l'étape c supérieure à la deuxième température.

8. Procédé selon l'une des revendications précédentes, dans lequel pour effectuer un recuit local on utilise un réseau chauffant (1) formé d'un grand nombre d'éléments chauffants (2), chaque élément chauffant (2) étant réglé à une première température calculée en fonction d'une valeur du rendement lumineux qui est préalablement mesuré en fonction de l'emplacement.

9. Procédé selon l'une des revendications précédentes, dans lequel on utilise un scanner (6) ou une caméra CCD pour mesurer localement le rendement lumineux.

10. Procédé selon l'une des revendications précédentes, dans lequel la couche de substance luminescente (4) est fabriquée à partir d'un halogénure de métal alcalin dopé.

11. Procédé selon le revendication 10, dans lequel l'halogénure de métal alcalin dopé est choisi dans le groupe suivant : CsBr:Eu, Csl:Tl, Csl:Na, RbBr:Eu, RbBr:Tl.

12. Dispositif pour la mise en oeuvre du procédé selon l'une des revendications précédentes, comprenant un dispositif (6) destiné à mesurer localement le rendement lumineux d'une couche de substance luminescente (4), un réseau chauffant (1) constitué d'un grand nombre d'éléments chauffant (2) pouvant être commandés individuellement et un dispositif (5) destiné à commander les éléments chauffants (2) en fonction des valeurs mesurées du rendement lumineux.

13. Dispositif selon la revendication 12, dans lequel une source de rayons X (8) est destinée à irradier la couche de substance luminescente (4).

14. Dispositif selon la revendication 12 ou 13, dans lequel le dispositif (6) destiné à mesurer localement le rendement lumineux comporte une caméra CCD ou un scanner comportant des éléments LED.
